(19) Europäisches Patentamt
European Patent Office
Office européen des brevets

(11) EP 3 091 636 A1

(12) EUROPÄISCHE PATENTANMELDUNG

(43) Veröffentlichungstag:
09.11.2016 Patentblatt 2016/45

(51) Int Cl.:
*H02J 50/12* (2016.01)

(21) Anmeldenummer: 16000992.4

(22) Anmeldetag: 03.05.2016

(84) Benannte Vertragsstaaten:
AL AT BE BG CH CY CZ DE DK EE ES FI FR GB
GR HR HU IE IS IT LI LT LU LV MC MK MT NL NO
PL PT RO RS SE SI SK SM TR
Benannte Erstreckungsstaaten:
BA ME
Benannte Validierungsstaaten:
MA MD

(30) Priorität: 07.05.2015 DE 102015005927

(71) Anmelder: Finepower GmbH
85737 Ismaning (DE)

(72) Erfinder: Heiland, Georg
81925 München (DE)

(54) VERFAHREN ZUR ADAPTIVEN KOMPENSATION EINES SCHWINGKREISES

(57) Die Erfindung betrifft ein Verfahren zur adaptiven Kompensation eines Schwingkreises. Eine Vorrichtung, bestehend aus mindestens 2 Kondensatoren, welche zueinander parallel oder in Reihe geschaltet werden können, wobei für jeden Kondensator mindestens ein Schalter vorhanden ist, der durch ein Steuersignal den Kondensator vom Stromkreis trennen kann, kann durch das erfindungsgemäße Verfahren eine Variation der Gesamtkapazität herbeiführen, wodurch beispielsweise eine möglichst optimale Kompensation der durch unterschiedliche Spulenpositionen einer induktiven Energieübertragung verursachten variablen Kopplung und damit Schwingkreisgüte erreicht wird.

FIG 5

EP 3 091 636 A1

**Beschreibung**

Die Erfindung betrifft ein Verfahren zur adaptiven Kompensation eines Schwingkreises.

Zur elektrischen Energieübertragung, insbesondere zur Ladung von Energiespeichern, werden immer öfter sogenannte resonante Topologien eingesetzt, die einen Schwingkreis beinhalten. Durch eine Anregung eines solchen Schwingkreises mit einer Frequenz, die im Bereich der Resonanzfrequenz des Schwingkreises liegt, können die frequenzabhängigen Übertragungseigenschaften des Schwingkreises dazu benutzt werden, um zum Einen über die Variation der Anregungsfrequenz eine Regelung zu ermöglichen, zum Anderen um die Schaltverluste durch sogenanntes Null-Spannungs-Schalten gering zu halten und so die Effizienz zu steigern.

Getrieben durch eine rasch zunehmende Vielfalt der am Markt befindlichen elektrischen Verbraucher wie beispielsweise Elektrofahrzeuge oder Multimediageräte, ergeben sich immer neue Anforderungen der Aufladung der Energiespeicher solcher Verbraucher. Dabei haben die Verbraucher sehr unterschiedlich geartete Energiespeicher, die sowohl in ihrer Spannungslage als auch in ihrem Spannungs- und Leistungsbereich unterschiedlichste Anforderungen an ein Lademanagement stellen.

Besonders bei beweglichen Objekten spielt außerdem der Komfort eine große Rolle. Daher geht der Trend immer mehr hin zu einer kabellosen, meist induktiven Aufladung der Energiespeicher. Die Vorteile dieser Technik wie fehlende störende Kabelverbindungen, inhärenter Berührschutz durch galvanische Netztrennung oder optische Unsichtbarkeit und dadurch Robustheit vor Vandalismus vor Allem an öffentlichen Ladepunkten lassen den Nachteil einer niedrigeren Effizienz gegenüber kabelgebundenen Ladetechniken sehr klein erscheinen.

Ein induktives Energieübertragungssystem besteht grundsätzlich aus 2 elektrisch voneinander isolierten Stromkreisen, wobei der Stromkreis, der die Energie bereitstellt oder stationär verbaut ist, meist als Primär- oder Sendestromkreis bezeichnet wird, und der andere Stromkreis als sekundärer oder Empfängerkreis bezeichnet wird und üblicherweise direkt in dem beweglichen Verbraucher integriert ist. Jeder Stromkreis besteht dabei aus einem leistungselektronischen Stellglied und einem Schwingkreis, der auch die Übertragerspule beinhaltet, damit Energie über ein magnetisches Feld von einem auf den anderen Stromkreis übertragen werden kann.

Eine wichtige ausschlaggebende Eigenschaft eines induktiven Energieübertragungssystems ist dabei die starke Abhängigkeit der Energieübertragungsfähigkeit von der räumlichen Anordnung von Sende- und Empfangseinheit zueinander. Aus diesem Grund gibt es bereits viele Ansätze, wie diese Anordnung so gesteuert werden kann, dass sich eine möglichst effiziente Energieübertragung einstellen kann.

Auf dem derzeitigen Stand der Technik liegt der Fokus auf den folgenden Punkten:

- Erreichung einer möglichst hohen Kopplung durch Positionierungssysteme oder mechanisches Design
- Minimierung der Blindleistungsaufnahme durch Primärstrom-Messung und -auswertung
- Kompensation der induktiven Strecke durch fest eingebaute kapazitive Elemente

Alle derzeit verfügbaren Lösungen zur Optimierung der Energieübertragung setzen auf Prävention, d.h. Vermeidung einer unnötig schlechten Kopplung. Dabei wird teilweise ein sehr hoher Aufwand betrieben, um beispielsweise durch komplizierte Positionierungsalgorithmen einen beweglichen Verbraucher so in Position zu bringen, dass dies eine optimale Passung für das induktive System darstellt. Umgekehrt gibt es ebenfalls Ansätze, durch eine bewegliche Primärseite eventuelle Fehlstellungen des mobilen Teils auszugleichen.

So beschreibt die DE102009017553A1 ein mechanisches Design einer induktiven Ladeeinheit in Form und Ausgestaltung sehr ähnlich zu einer Zapfpistole, womit eine definierte Betriebsanordnung sichergestellt wird. Hier stellt sich die Frage nach dem Komfortvorteil, da hier ähnlich wie zum kabelgebundenen Laden ebenfalls eine Ladeleitung bis zum Verbraucher geführt ist und lediglich der Berührschutz durch die galvanische Trennung den Vorteil aufrecht erhält.

Die DE4236286A1 beschreibt ein Verfahren und eine Anordnung zum automatischen berührungslosen Laden, wobei hier zuerst die Empfängerseite in eine Näherungsposition zur Sendeseite gebracht wird und anschließend die Sendeeinheit über elektromechanische Aktoren exakt positioniert wird. Durch diese 2-fache Positionierungsaufgabe ist sehr viel Zusatzaufwand in Form von Sensoren und Aktoren notwendig, welche die Kosten und die Komplexität des Gesamtsystems erhöhen und die Flexibilität senken.

In der DE102011010134A1 ist eine Vorrichtung beschrieben, die induktive Energieübertragung über das Nummernschild eines Fahrzeugs ermöglicht, wobei die Primärseite wieder in 2 Raumachsen beweglich ist, um versetzt parkende Fahrzeuge auszugleichen.

Es gibt weitere Verfahren, die durch elektronische Kompensation Veränderungen der Schwingkreiseigenschaften detektieren und ausgleichen können.

Beispielsweise offenbart die DE19621076C2 ein Verfahren, in dem einem Element des Resonanzkreises phasenanschnittsgesteuert eine weitere, feste Impedanz zugeschaltet werden kann, um somit eine Schwingkreisverstimmung aufgrund von Bauteiltoleranzen, Alterungs- und Temperatureinflüssen stufenlos auszuregeln. Dieses Verfahren erfordert einen hohen, wenn auch dem Zweck dienlichen Aufwand für eine exakte und schnelle Resonanzstrommessung, jedoch entstehen durch die Schaltvorgänge sehr hohe Stromflanken und damit durch die induktiven Elemente hohe Spannungen, welche in einem Betrieb ohne phasenweise Zuschaltung einer Impedanz nicht auftreten würden, was zu einer erhöhten Anforderung an die Bauteilbemessungen führt.

In der DE102013226219A1 wird eine Ladevorrichtung offenbart, welche einem Element eines Resonanzkreises einen oder mehrere ohmsche Widerstände parallelschaltet, welche über jeweils einen Schalter einzeln zu- oder weggeschaltet werden können. Dadurch kann auf einfache Art und Weise die Schwingkreisgüte verändert bzw. Änderungen der Schwingkreisgüte aufgrund von Temperatur und Alterung ausgeglichen werden. Der Nachteil liegt hier darin, dass dann in den ohmschen Widerständen durch den Stromfluss ohmsche Verluste erzeugt werden, welche zum Einen die Effizienz eines induktiven Energieübertragungssystems senken, zum Anderen durch die zusätzliche Wärmeentwicklung weitere Temperaturänderungen hervorrufen können, welche den Effekt der Kompensation schmälern. Des Weiteren ist in dieser Vorrichtung durch ein entsprechendes mechanisches Design eine konstante Kopplung vorhanden, wodurch sich die Resonanzfrequenz nicht oder nur sehr wenig ändert.

Die DE60319665T2 offenbart ein Verfahren zur Abstimmung eines LC-Resonators, welches eine parallele Zuschaltung einer variablen Kapazität umfasst. Dabei wird durch Einstellung der minimalen Kapazität - im Falle von separaten parallel geschalteten Kondensatoren mit in Reihe geschalteten Schaltern also nur des Schließens des Schalters, der dem Kondensator mit dem niedrigsten Kapazitätswert in Reihe geschaltet ist - die maximale Resonanzfrequenz gemessen, und durch Einstellen der maximalen Kapazität entsprechend die minimale Resonanzfrequenz gemessen. Die beiden Frequenzwerte werden in einem Speicher abgelegt und daraus durch Interpolation der gemessenen Werte eine bestimmte Soll-Resonanzfrequenz erzeugt. Damit kann eine Empfänger-Antenne schnell auf eine von einem Sender bereitgestellte Trägerfrequenz eingestellt werden, ohne dass ein aktiver Steuermechanismus mit Rückkopplung erforderlich ist. Dieses Verfahren könnte prinzipiell auch zur Veränderung der Resonanzfrequenz in einem induktiven Energieübertragungssystem eingesetzt werden; jedoch ist durch die Methode der Interpolation zwischen lediglich zwei gemessenen Maximal- bzw. Minimalwerten der Resonanzfrequenz keine optimale Kompensation der Energieübertragung möglich, da hier zusätzlich auf die jeweilige situationsabhängige variable Kopplung und damit variable Resonanzinduktivität geachtet werden muss. Zudem ändert sich die Resonanzfrequenz mit der Belastung der Empfängerseite, wodurch die Übertragungsfrequenz nicht konstant gehalten sondern zur Regelung der Energieübertragung geringfügig variiert wird, sodass eine durch Interpolation theoretisch ermittelte Konfiguration der Kapazitätswerte in bestimmten Betriebsbereichen unzureichend wäre. Nicht zuletzt sind Kondensatoren an sich toleranzbehaftet, sodass eine Interpolation keine zuverlässige Frequenzeinstellung ermöglicht.

Ein weiterer Grund für einen solch hohen Optimierungsaufwand ergibt sich aus der Tatsache, dass immer ein möglichst sinusförmiger und damit oberwellenarmer Feldverlauf angestrebt wird, um sowohl die elektromagnetische Verträglichkeit als auch die Verlustleistung im optimalen Bereich zu halten. Dies bedingt einen Betrieb der Anordnung immer genau im Resonanzpunkt, weil nur bei einer bestimmten Anregungsfrequenz, der sogenannten Resonanzfrequenz, ein rein sinusförmiger Strom und damit rein sinusförmiges Magnetfeld erzeugt wird. Durch die Eigenschaft eines jeden Resonanzkreises, bei der Resonanzfrequenz eine minimale Impedanz zu besitzen, wird jedoch die Amplitude des Stroms sehr groß und macht eine Stromregelung notwendig, die wiederum zu einer geringen Abweichung von einem idealen sinusförmigen Stromverlauf führt.

Wird das System weit ab von der Resonanzfrequenz betrieben, kann nahezu keine Energie übertragen werden. Dies macht die oben beschriebenen Maßnahmen wie Positionierung bzw. Kompensation notwendig.

Es ergibt sich durch die beschriebenen Lösungen der Nachteil eines hohen Kostenfaktors durch ein stationäres oder mobiles Positionierungssystem, sowie geringe Abstandstoleranzen, unzureichende Flexibilität und Effizienzeinbußen durch ein bekanntes Kompensationsnetzwerk, wenn zugleich auf Positionierungsmaßnahmen verzichtet werden soll. Durch die vielfältigen, zueinander sehr unterschiedlichen Anwendungsmöglichkeiten für unterschiedliche Verbraucher sind vergleichsweise geringe Stückzahlen für jeweils einen konkreten Anwendungsfall zu erwarten, wodurch die Stückpreise nicht konkurrenzfähig zu konventionellen kabelgebundenen Ladesystemen sind, wenn für jeden Anwendungsfall eine speziell darauf abgestimmte Resonanztopologie zum Einsatz kommt.

Es stellt sich die Frage nach einer Möglichkeit, ohne hohen Positionierungs-, Strommess- oder Designaufwand eine möglichst universelle, toleranz-tolerierende Energieübertragung mit möglichst wenig zusätzlichem Aufwand für eine Strommessung oder Ansteuerstrategie zu ermöglichen.

Diese Aufgabe wird durch ein Verfahren mit den Merkmalen des Anspruchs 1 gelöst. Weitere günstige Ausführungsformen ergeben sich aus den Unteransprüchen.

Das vorgeschlagene Verfahren kann zum Betrieb einer Vorrichtung herangezogen werden, welche aus zumindest 2 Kondensatoren sowie mindestens einem Schaltelement besteht, welches mit zumindest einem Kondensator in Reihe oder parallel elektrisch verbunden ist, wobei die Vorrichtung Teil eines Resonanznetzwerks ist.

Ein Schaltelement, im Folgenden auch als Schalter bezeichnet, besitzt zweckmäßig zwei Anschlüsse, wobei der Schalter in der Lage sein muss, sowohl Strom in beide Richtungen zu leiten als auch Spannungen beider Polaritäten zu sperren. Der Schalter kann hierbei ein Relais oder auch ein Halbleiterschalter sein, solange er die o.g. Voraussetzungen erfüllt. Weiterhin kann dieser Schalter auch durch 2 antiserielle MOSFETs oder IGBTs oder dergleichen realisiert werden, die durch dasselbe Steuersignal angesprochen werden. Der Einfachheit halber wird aber im Folgenden immer nur von einem "Schalter" oder "Schaltelement" gesprochen. Ein Schalter kann dabei zweckmäßig die beiden Zustände "geschlossen" oder "offen" einnehmen, welche durch ein Steuersignal definiert werden. Dabei ist für jeden Schalter eine separate Steuermöglichkeit vorhanden. Die Gesamtheit aller einzelnen Schalterzustände wird folgend als "Schalterzustands-Konfiguration" bezeichnet.

Die Vorrichtung kann dabei umfassen: Kondensatoren, die elektrisch parallel oder in Reihe zueinander geschaltet sind, wobei die Schaltelemente bei Parallelschaltung in Reihe zu mindestens einem Kondensator verbunden sind, bei Reihenschaltung jedoch parallel dazu. Dies lässt bei Parallelschaltung eine Zu- oder Abschaltung des zumindest einen Kondensators vom Resonanzkreis zu, bei Reihenschaltung können die Kondensatoren einfach durch Schließen des Schaltelements überbrückt werden. Eine solche Verbindung aus zumindest einem Kondensator, dem ein Schalter elektrisch parallel oder in Reihe geschaltet ist, wird für die folgenden Erläuterungen als "Schalter-Kondensator-Kombination" bezeichnet, die die zwei Varianten "seriell" (Schalter in Reihe zu einem oder mehreren Kondensatoren) oder "parallel" (Schalter parallel zu einem oder mehreren Kondensatoren) besitzt.

Es können dabei beliebig viele Schalter-Kondensator-Kombinationen zueinander elektrisch parallel oder in Reihe geschaltet werden, wobei eine Parallelschaltung nur für serielle Schalter-Kondensator-Kombinationen sinnvoll ist, da ansonsten durch eine parallele Schalter-KondensatorKombination alle weiteren parallel geschalteten Zweige überbrückt werden. Weiterhin kann die Vorrichtung auch eine Kombination aus in Reihe und parallel geschalteten Schalter-Kondensator-Kombinationen enthalten.

Das vorgeschlagene Verfahren kann in vorteilhafter Weise angewendet werden, wenn die Vorrichtung Teil eines Resonanznetzwerks ist, insbesondere einer induktiven Energieübertragungseinheit, wobei die Vorrichtung der Primärspule des induktiven Systems elektrisch in Reihe geschaltet wird und über die elektrischen Anschlüsse zwischen eine aktive Brückenschaltung und die Primärspule geschaltet wird. Alternativ kann die Vorrichtung auch einem bereits im Schwingkreis vorhandenen Kondensator parallel oder in Reihe geschaltet werden. Somit ergibt sich aus der Zusammenschaltung der beschriebenen Vorrichtung und der Übertragerspule ein Resonanzkreis. Dieser Resonanzkreis kann dann durch eine von der aktiven Brückenschaltung erzeugte Wechselspannung zur Energieübertragung angeregt werden.

Mit der beschriebenen Vorrichtung wird erreicht, dass in Abhängigkeit der jeweiligen Schalterzustands-Konfiguration unterschiedliche resultierende Gesamtkapazitätswerte entstehen, womit die Resonanzkreis-Güte sowie deren Resonanzfrequenz verändert wird. Dies bewirkt eine Änderung der Übertragungscharakteristik des Resonanzkreises sowohl im Amplituden- als auch im Phasengang. Wird mit derselben Frequenz angeregt, ergeben sich durch eine Veränderung der Kapazität eine andere Stromform, -amplitude sowie -phase gegenüber der anregenden Wechselspannung.

Dadurch kann zum Einen eine Anpassung bzw. Kompensation der induktiven Übertragungsstrecke vorgenommen werden, zum Anderen erzeugt diese Maßnahme exakt dieselben Effekte wie eine Veränderung bzw. Optimierung der Kopplung, sprich Resonanzinduktivität, mit dem Vorteil, dass auf eine Positionierung verzichtet werden kann.

Die beschriebene Vorrichtung macht sich den Nachteil der niedrigen und zudem variablen Kopplung der Übertragerspulen zunutze, wie sie bei einer induktiven Energieübertragung ohne Positionierungsmaßnahmen üblicherweise auftritt. Dabei wirkt die durch die niedrige Kopplung erzeugte hohe Streuinduktivität als Resonanzinduktivität, welche in Verbindung mit der vorgeschlagenen Vorrichtung und der Übertragerspule einen sogenannten "LLC"-Schwingkreis bildet.

Außerdem kann mit der Vorrichtung und dem vorgeschlagenen Verfahren ebenfalls ein System mit hoher Kopplung vorteilhaft betrieben werden, indem durch die Möglichkeit der Veränderung der Gesamtkapazität die Resonanzeigenschaften verändert und dadurch in einem größeren Spannungs- oder Leistungsbereich eine höhere Performance erreicht wird.

Im Folgenden wird das vorgeschlagene Verfahren zum Betrieb einer vorbeschriebenen Vorrichtung zur adaptiven Kompensation in einem System bestehend aus einer aktiven Brückenschaltung und einem Schwingkreis beschrieben. Zu Beginn der Energieübertragung werden unterschiedliche Schalterzustands-Konfigurationen eingerichtet und sodann die Energieübertragung durch Ansteuerung der aktiven Brücke gestartet. Daraufhin wird der Amplitudenwert des Primärstroms sowie dessen Vorzeichen der Phasenlage gegenüber der anregenden, durch die aktive Brückenschaltung erzeugten Wechselspannung gemessen. Diese Prozedur wird mit unterschiedlichen, im Idealfall allen möglichen Schalterzustands-Konfigurationen wiederholt. Durch einen Vergleich der Amplitudenwerte sowie deren qualitativen Änderungen in Bezug auf die Schalterzustände, deren Konfiguration einen bestimmten Gesamt-Kapazitätswert ergibt, der bekannt ist, kann die jeweils bestmögliche Schalterzustands-Konfiguration ermittelt werden. Dabei ist diejenige Konfiguration optimal, welche das höchste Verhältnis aus Stromamplitude zu resultierender Gesamt-Kapazität liefert, wobei der Primärstrom der anregenden Wechselspannung nacheilen muss.

Ist der Primärstrom voreilend, ergibt sich die optimalste Konfiguration durch das niedrigste Verhältnis aus Stromamplitude und resultierender Gesamt-Kapazität, jedoch ist dieses Vorzeichen der Phasenlage ungünstig für den Betrieb einer induktiven Übertragungsstrecke, da hier mehr Verluste in den elektronischen Komponenten entstehen.

Die explizite Berechnung dieses Quotienten ist aber nicht notwendig; es reicht die Messung der Amplitude bei Kenntnis des Vorzeichens der Phasenlage aus. Jedoch muss dieses Verfahren dann eingesetzt werden, wenn beispielsweise in einem induktiven Übertragungssystem eine sehr hohe Kopplung vorhanden ist, welche zu einer Resonanzfrequenz führt, die höher als die maximal mögliche Ansteuerfrequenz der Leistungselektronik ist. Dadurch kann der Betriebsbereich mithilfe der vorgeschlagenen Vorrichtung erweitert werden.

Das Verfahren kann anstatt des reinen Vorzeichens der Phasenlage auch den zahlenmäßigen Phasenwinkel erfassen, jedoch bietet dies hinsichtlich des Ziels der optimalen Schalterzustands-Konfiguration keinen weiteren Vorteil.

Des Weiteren kann dieses Verfahren auch während eines Energieübertragungs-Vorgangs jederzeit wiederholt werden, um etwaige Veränderungen im System zu detektieren.

Eine günstige Ausführungsform für die Erfassung und Auswertung der Resonanzstrom-Amplitude sowie des Phasenwinkels beziehungsweise des Vorzeichens des Phasenwinkels ist dabei die Verwendung von analoger Schaltungstechnik oder auch die Umwandlung der Messwerte aus den Messeinrichtungen in digitale Werte und anschließende digitale Verarbeitung. Die Erfassungs- und Auswerteeinheit liefert die für eine Optimierung der adaptiven Kompensation notwendigen Informationen, die eine Steuereinheit zur Ausführung der Aufgabe nutzt.

Die Steuereinheit kann ein speicherprogrammierbares logisches Bauelement oder ein Prozessor wie z.B. Mikrocontroller, DSP, FPGA oder CPLD sein. Durch ein speicherprogrammierbares Bauelement können unterschiedliche Ergebnisse miteinander verglichen werden und für zukünftige Energieübertragungsvorgänge wiederverwendet werden.

In einer weiteren günstigen Ausführungsform erzeugt die Erfassungs- und Auswerteeinheit ein Signal, das der Steuereinheit anzeigt, wann die Konfigurationsphase aktiv ist, während der eine feste Anregungsfrequenz des Schwingkreises eingestellt werden soll. Zusätzlich kann die Steuerelektronik während der Konfigurationsphase durch ein weiteres Signal aktiviert und deaktiviert werden. Damit kann beispielsweise eine eigenständige erfindungsgemäße Vorrichtung realisiert werden, welche einem beliebigen Schwingkreis zugeschaltet werden kann.

In der Konfigurationsphase, während der Suche nach der optimalen Schalterzustands-Konfiguration, ist dabei in einer bevorzugten Ausgestaltung eine feste, aber im Rahmen der üblichen Grenzen für eine induktive Energieübertragung für eine bestimmte Anwendung frei wählbare Frequenz der anregenden Wechselspannung möglich. Damit kann auf vorteilhafte Weise ein Vergleich der Resonanzstromamplitude und -phasenlage wie beschrieben durchgeführt werden und der Wert der Frequenz nach anderen Faktoren gewählt werden.

Da in diesem Verfahren rein elektronische Vorgänge wie das Ansteuern von Halbleitern oder Relais vorhanden sind und diese in der Regel wesentlich schneller ablaufen als mechanische Vorgänge wie beispielsweise die Bewegung von Massen, kann mit dem vorgeschlagenen Verfahren eine induktive Energieübertragung schneller und effizienter ablaufen. Dadurch sind auch weitere Lademöglichkeiten an Orten gegeben, an denen Positionierungs- und Kommunikationsmöglichkeiten nicht vorhanden oder nicht sinnvoll sind, beispielsweise für Elektrofahrzeuge an Ampelanlagen oder Kurzparkzonen.

Diese Eigenschaft führt außerdem zu einer wesentlichen Kostenersparnis im Vergleich zu einem aufwändigen Positionierungs- und Kommunikationssystem.

Die Erfindung wird anhand FIG 1 und 5 sowie mehrerer Ausführungsbeispiele mit FIG 2 bis 4 im Folgenden näher erläutert.

FIG 1 zeigt eine schematische Darstellung eines dem Stand der Technik entsprechenden Systems zur induktiven Energieübertragung

FIG 2 zeigt ein erstes Ausführungsbeispiel einer Vorrichtung, auf welche das vorgeschlagene Verfahren angewendet werden kann

FIG 3 zeigt ein zweites Ausführungsbeispiel einer Vorrichtung, auf welche das vorgeschlagene Verfahren angewendet werden kann

FIG 4 zeigt ein drittes Ausführungsbeispiel einer Vorrichtung, auf welche das vorgeschlagene Verfahren angewendet werden kann

FIG 5 zeigt den qualitativen Frequenzgang eines Schwingkreises und dessen Abhängigkeit von der Gesamtkapazität

Nachfolgend sind gleiche Komponenten mit denselben Bezugszeichen gekennzeichnet.

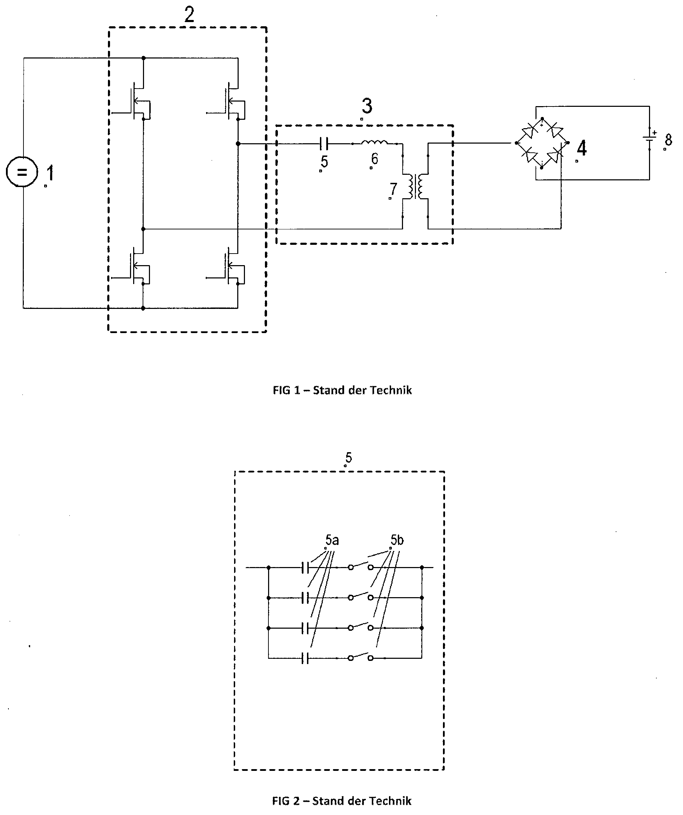

FIG 1 zeigt ein Prinzip-Schaltbild eines typischen Stromkreises für eine induktive Energieübertragung. Ein Schwingkreis (3) wird durch eine aktive Brücke (2) aus einer Gleichspannungsquelle (1) durch Erzeugung pulsförmiger, uni- oder bipolarer Spannungsblöcke, angeregt. Dadurch fließt ein sinusförmiger Wechselstrom, dessen Frequenz sich aus den Werten für die Kapazität (5) sowie die Resonanzinduktivität (6) ergibt, sowie dessen Amplitude ein Resultat aus dem Verhältnis der (komplexen) Spannungs- und Impedanzwerte ist. Über ein magnetisch gekoppeltes Spulenpaar (7) wird ein bestimmter Teil der erzeugten Momentanleistung durch ein magnetisches Wechselfeld auf die sekundäre Empfangsspule (7) übertragen und dort eine Spannung induziert, welche über einen Gleichrichter (4) einem Verbraucher (8) zugeführt wird.

FIG 2 zeigt ein erstes Ausführungsbeispiel einer geeigneten Vorrichtung, auf welche das vorgeschlagene Verfahren angewendet werden kann, in dem eine Parallelschaltung von vier Kondensatoren (5a) vorgesehen ist, wobei jedem Kondensator (5a) ein Schaltelement (5b) in Reihe geschaltet ist, mit dem jeder einzelne Kondensator (5a) vom Schwingkreis (3) getrennt werden kann. Dadurch ist durch Schließen eines Schalters (5b) eine Vergrößerung, durch Öffnen eine Verkleinerung der Gesamtkapazität möglich. Beispielhaft für die abgebildete Parallelschaltung von 4 Kondensatoren (5a) können durch Einzelkapazitätswerte von 22 nF, 33 nF, 47 nF und 100 nF folgende Gesamtkapazitäts-Werte erzeugt werden:

$$C = 22, 33, 47, 55, 69, 80, 100, 122, 133, 147 \text{ nF}.$$

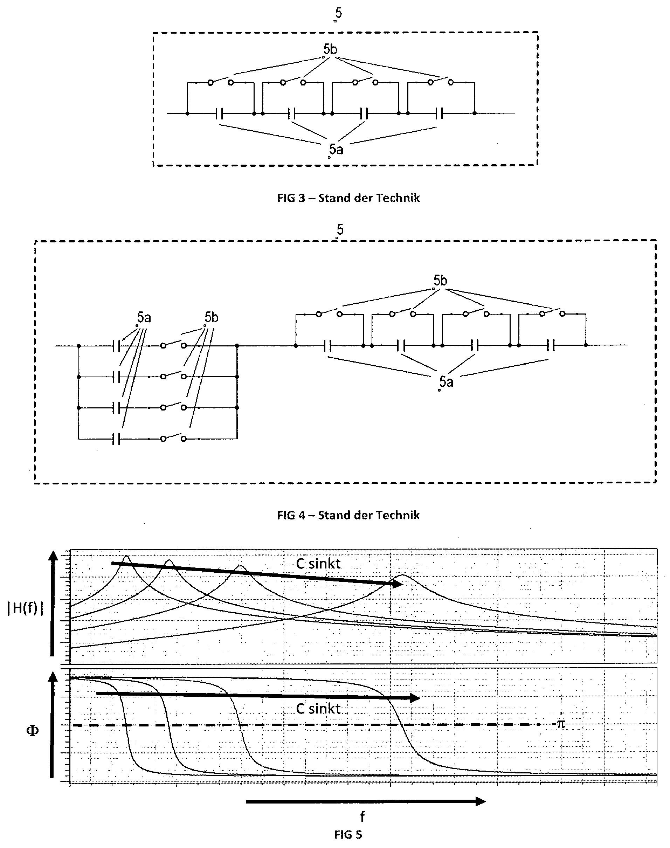

FIG 3 zeigt ein weiteres Ausführungsbeispiel einer geeigneten Vorrichtung, wobei hier eine reine Serienschaltung von vier Kondensatoren (5a) dargestellt ist. Jedem Kondensator (5a) wird in diesem Fall jeweils ein Schaltelement (5b) parallel geschaltet, durch dessen Schließen der jeweilige Kondensator (5a) überbrückt und dadurch stromlos geschaltet werden kann. Durch Schließen eines Schalters (5b) wird eine Vergrößerung, durch Öffnen eine Verkleinerung der Gesamtkapazität erreicht, im Unterschied zu dem Beispiel in FIG 2 ist dieser Zusammenhang zwischen Öffnen und Schließen jedoch nicht-linear und dadurch können andere Kapazitätswerte realisiert werden. Beispielhaft für dieselben Werte wie in FIG2 sind dies:

$$C = 0, 9, 10, 12, 13, 15, 16, 18, 19, 22, 25, 32, 33, 47, 100 \text{ nF}$$

Werden dabei 2 der in FIG3 abgebildeten Stränge (5) parallel geschaltet, ergeben sich durch diese beispielhafte Kombination wesentlich mehr unterschiedliche Werte, deren Abstand sehr fein ist:

$$C = 0, 9, 10, 12, 13, 15, 16, 18, 19, 20, 21, 22, 23, 24, 25, 26,\ldots38, 40, 41,\ldots52, 54, 55, 57, 58, 59, 60, 62, 63, 65, 66, 69, 72, 79, 80, 94, 100, 109, 110, 112, 113, 115, 116, 118, 119, 122, 125, 133, 147, 200 \text{ nF}.$$

FIG 4 zeigt eine Kombination aus Parallel- und Serienschaltung mehrerer Kondensatoren (5a) mit ihren jeweils erfindungsgemäß zugehörigen Schaltelementen (5b). Durch Wahl zueinander unterschiedlicher Werte der einzelnen Kondensatoren (5a) können dabei durch vergleichsweise wenig Bauteilaufwand viele unterschiedliche Gesamtkapazitäten realisiert werden.

Der qualitative Verlauf der frequenzabhängigen Strom-Übertragungsfunktion eines LLC-Schwingkreises ist in FIG5 dargestellt. Ferner sind in FIG5 mehrere Kennlinien eingetragen, deren Scharparameter die durch die vorgeschlagene Vorrichtung realisierte Gesamtkapazität bei ansonsten unveränderten Parametern ist. Mit sinkender resultierender Gesamtkapazität verschiebt sich der Punkt der maximalen Amplitude zu höheren Frequenzen, gleichzeitig nimmt die maximale Amplitude ab. Im Punkt der maximalen Amplitude wechselt die Phase gegenüber der anregenden Wechselspannung das Vorzeichen, was durch einen Durchtritt durch ($-\pi$) erkennbar ist. Wird ein solcher Schwingkreis mit unterschiedlich einstellbaren Kapazitätswerten immer mit derselben Frequenz angeregt und die Kapazität beispielsweise monoton verringert, wird die Amplitude des Resonanzstroms solange zunehmen, wie dessen Phase gegenüber der anregenden Wechselspannung nacheilt ($\Phi < -\pi$). Umgekehrt wird, solange die Phase der anregenden Wechselspannung voreilt ($\Phi > -\pi$), die Amplitude des Resonanzstroms bei sinkender Kapazität ebenfalls sinken. Ziel einer erfindungsgemäßen Adaption mithilfe des vorgeschlagenen Verfahrens der unterschiedlichen Schalterzustands-Konfigurationen ist es, diejenigen beiden, in ihren resultierenden Gesamtkapazitätswerten unmittelbar benachbarten, Konfigurationen zu finden, zwischen denen sich der Phasendurchtritt durch $-\pi$ vollzieht. Die optimale Konfiguration im Hinblick auf eine möglichst hohe Effizienz ist dann die Konfiguration, bei der die Phase des Resonanzstroms gegenüber der anregenden Wechselspannung nacheilt, selbst wenn die andere der beiden Konfigurationen einen höheren Amplitudenwert liefert.

Bezugszeichenliste

1    Gleichspannungsquelle
2    Aktive Brückenschaltung
3    Schwingkreis
4    Gleichrichter
5    Resonanzkapazität

5a    Kondensator

5b    Schaltelement

6    Resonanzinduktivität
7    Magnetisch gekoppeltes Spulenpaar
8    Verbraucher


**Patentansprüche**

**1.** Verfahren zur optimalen Konfiguration einer Vorrichtung zur adaptiven Kompensation eines Schwingkreises, bestehend aus zumindest zwei elektrisch miteinander verbundenen Kondensatoren, welchen jeweils ein Schaltelement elektrisch parallel oder in Reihe geschaltet ist, wobei die Vorrichtung mit einem Schwingkreis elektrisch verbunden werden kann, **gekennzeichnet durch** eine Vergleichsmessung der Resonanzstrom-Amplitude sowie des Vorzeichens des Phasenwinkels zwischen Resonanzstrom und anregender Wechselspannung unterschiedlicher Schalterzustands-Konfigurationen zu Beginn oder jederzeit während einer Energieübertragungsphase und anschließender Auswahl derjenigen Konfiguration für eine anschließende dauerhafte Energieübertragung, welche in der Vergleichsmessung den höchsten Amplitudenwert des Resonanzstroms bei gleichzeitiger voreilender Anregungs-Wechselspannung gegenüber dem Resonanzstrom oder aber den niedrigsten Amplitudenwert des Resonanzstroms bei gleichzeitiger nacheilender Anregungs-Wechselspannung gegenüber dem Resonanzstrom erzeugt.

**2.** Verfahren nach Anspruch 1, **gekennzeichnet dadurch, dass** die Werte für die Resonanzstrom-Amplitude sowie des Vorzeichens des Phasenwinkels zwischen Resonanzstrom und anregender Wechselspannung durch analoge Schaltungstechnik oder durch Umwandlung der Messwerte aus den Messeinrichtungen in digitale Werte und anschließender digitaler Verarbeitung ermittelt werden.

**3.** Verfahren nach Anspruch 1 oder 2, **dadurch gekennzeichnet, dass** die gesamte Steuerung durch ein speicherprogrammierbares logisches Bauelement oder einen Prozessor wie z.B. Mikrocontroller, DSP, FPGA oder CPLD erfolgt.

**4.** Verfahren nach einem der Ansprüche 1 bis 3, **gekennzeichnet dadurch, dass** die Steuerelektronik einer die anregende Wechselspannung erzeugenden aktiven Brücke durch eine mit dem vorgeschlagenen Verfahren betriebene Vorrichtung ein Signal erhält, welches die Steuerelektronik aktivieren und deaktivieren kann, sowie die Konfigurationsphase anzeigt, während der eine feste Anregungsfrequenz des Schwingkreises eingestellt werden soll.

FIG 1 – Stand der Technik

FIG 2 – Stand der Technik

FIG 3 – Stand der Technik

FIG 4 – Stand der Technik

FIG 5

Europäisches
Patentamt

European
Patent Office

Office européen
des brevets

# EUROPÄISCHER RECHERCHENBERICHT

**Nummer der Anmeldung**

EP 16 00 0992

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | WO 2012/085097 A2 (AIRBUS OPERATIONS GMBH [DE]; BAUER HANS-ACHIM [DE]; ZYBALA ANDRE [DE];) 28. Juni 2012 (2012-06-28) * Seite 5, Zeilen 7-11 * * Seite 10, Zeilen 10-16 * * Seite 11, Zeilen 21-28 * ----- | 1-4 | INV. H02J50/12 |
| A | US 2006/192628 A1 (SCHULMAN JOSEPH H [US] ET AL) 31. August 2006 (2006-08-31) * Absätze [0005], [0008], [0041]; Abbildung 14 * ----- | 1-4 | |
| A | FR 2 997 806 A1 (PEUGEOT CITROEN AUTOMOBILES SA [FR]) 9. Mai 2014 (2014-05-09) * Zusammenfassung; Abbildungen 1,2a,2b * ----- | 1-4 | |

**RECHERCHIERTE SACHGEBIETE (IPC)**

H02J
H03J

Der vorliegende Recherchenbericht wurde für alle Patentansprüche erstellt

| Recherchenort | Abschlußdatum der Recherche | Prüfer |
|---|---|---|
| München | 21. September 2016 | Hanisch, Thomas |

KATEGORIE DER GENANNTEN DOKUMENTE

X : von besonderer Bedeutung allein betrachtet
Y : von besonderer Bedeutung in Verbindung mit einer
    anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
    nach dem Anmeldedatum veröffentlicht worden ist
D : in der Anmeldung angeführtes Dokument
L : aus anderen Gründen angeführtes Dokument

...............................................................
& : Mitglied der gleichen Patentfamilie, übereinstimmendes
    Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 16 00 0992

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

21-09-2016

| Im Recherchenbericht angeführtes Patentdokument | Datum der Veröffentlichung | Mitglied(er) der Patentfamilie | Datum der Veröffentlichung |
|---|---|---|---|
| WO 2012085097 A2 | 28-06-2012 | CN 103269951 A<br>DE 102010055696 A1<br>EP 2655188 A2<br>US 2013278053 A1<br>WO 2012085097 A2 | 28-08-2013<br>28-06-2012<br>30-10-2013<br>24-10-2013<br>28-06-2012 |
| US 2006192628 A1 | 31-08-2006 | EP 1703638 A1<br>US 2006192628 A1 | 20-09-2006<br>31-08-2006 |
| FR 2997806 A1 | 09-05-2014 | KEINE | |

EPO FORM P0461

Für nähere Einzelheiten zu diesem Anhang : siehe Amtsblatt des Europäischen Patentamts, Nr.12/82

**EP 3 091 636 A1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102009017553 A1
- DE 4236286 A1
- DE 102011010134 A1
- DE 19621076 C2
- DE 102013226219 A1
- DE 60319665 T2